# EUROPEAN PATENT APPLICATION

(11) **EP 4 694 641 A1**
(43) Date of publication of application: **11.02.2026**
(21) Application number: 24777729.5
(22) Date of filing: 13.03.2024
(51) Int. Cl.: H10K 59/12

(54) **DISPLAY PANEL, DISPLAY DEVICE, AND MANUFACTURING METHOD FOR DISPLAY PANEL**

(30) Priority: 31.03.2023 CN 202310340296; 24.04.2023 CN 202310446277; 25.09.2023 CN 202311239306
(71) Applicant: Visionox Technology Inc., Suzhou, Jiangsu 215300 (CN)
(72) Inventor: WU, Jian, Suzhou, Jiangsu 215300 (CN); NI, Liusong, Suzhou, Jiangsu 215300 (CN); YAO, Yuan, Suzhou, Jiangsu 215300 (CN); ZHANG, Haohan, Suzhou, Jiangsu 215300 (CN); FU, Wenyue, Suzhou, Jiangsu 215300 (CN); DONG, Zhengkui, Suzhou, Jiangsu 215300 (CN); WANG, Tian, Suzhou, Jiangsu 215300 (CN); LI, Junfeng, Suzhou, Jiangsu 215300 (CN)
(74) Representative: Kraus & Lederer PartGmbB
(86) International application number: PCT/CN2024/081472
(87) International publication number: WO 2024/198939

(57) **Abstract**

The present application relates to a technical field of display, and in particular, to a display panel, a display apparatus, and a method for manufacturing a display panel. The present application discloses a display panel, including a substrate, a pixel defining layer, and an encapsulation layer. The pixel defining layer is arranged on the substrate. The encapsulation layer is located on a side of the pixel defining layer facing away from the substrate. The encapsulation layer includes a first encapsulation layer. The first encapsulation layer is provided with a first opening penetrating through the first encapsulation layer along a thickness direction. The present application further discloses a display apparatus, including the above display panel. The present application further discloses a method for manufacturing a display panel, applied to the display panel as above.

## Description

### CROSS-REFERENCE TO RELATED APPLICATIONS

The present application claims priority to Chinese Patent Application No. 202310340296.0, entitled "DISPLAY PANEL AND DISPLAY APPARATUS" and filed on March 31, 2023, which is hereby incorporated by reference in its entirety. The present application claims priority to Chinese Patent Application No. 202310446277.6, entitled "DISPLAY PANEL AND DISPLAY APPARATUS" and filed on April 24, 2023, which is hereby incorporated by reference in its entirety. The present application claims priority to Chinese Patent Application No. 202311239306.8, entitled "DISPLAY PANEL, DISPLAY APPARATUS, AND METHOD FOR MANUFACTURING DISPLAY PANEL" and filed on September 25, 2023, which is hereby incorporated by reference in its entirety.

### TECHNICAL FIELD

The present application relates to the technical field of display, and in particular, to a display panel, a display apparatus, and a method for manufacturing a display panel.

### BACKGROUND

An organic light emitting diode (OLED) and a flat panel display apparatus based on a light emitting diode (LED) technology and the like are widely used in various consumer electronic products such as mobile phones, TVs, notebook computers, and desktop computers due to advantages such as high image quality, power saving, a thin body, and a wide range of applications, becoming the mainstream in display apparatuses.

However, performance of current OLED display products needs to be improved.

### SUMMARY

Embodiments of the present application provide a display panel and a display apparatus, intended to improve performance of the display panel.

An embodiment of a first aspect of the present application provides a display panel, including a substrate, a pixel defining layer, and an encapsulation layer. The pixel defining layer is arranged on the substrate. The encapsulation layer is located on a side of the pixel defining layer facing away from the substrate. The encapsulation layer includes a first encapsulation layer. The first encapsulation layer is provided with a first opening penetrating through the first encapsulation layer along a thickness direction.

In another aspect, an embodiment of a second aspect of the present application further provides a display panel, including a substrate, a pixel defining layer, a first electrode layer, and a first conductive line. The pixel defining layer is arranged on the substrate. The pixel defining layer includes a pixel defining portion and a pixel opening surrounded by the pixel defining portion. A light-emitting layer is provided in the pixel opening. The first electrode layer is located on a side of the light-emitting layer facing away from the substrate. The first conductive line includes a first conductive portion. The first conductive portion is located between the substrate and the pixel defining layer, and the first conductive portion is electrically connected to the first electrode layer.

In another aspect, an embodiment of a third aspect of the present application further provides a display panel, including a substrate, a pixel defining layer, a first electrode layer, and a first conductive line. The pixel defining layer is arranged on the substrate. The pixel defining layer includes a pixel defining portion and a pixel opening surrounded by the pixel defining portion. A light-emitting layer is provided in the pixel opening. The first electrode layer is located on a side of the light-emitting layer facing away from the substrate. The first conductive line is located on a side of the pixel defining layer away from the substrate. The first conductive line is connected with the first electrode layer in an overlap manner.

In another aspect, an embodiment of a fourth aspect of the present application further provides a display panel, including a substrate, a pixel defining layer, and an encapsulation layer. The pixel defining layer is arranged on the substrate. The pixel defining layer includes a pixel opening, and a light-emitting layer is provided in the pixel opening. The encapsulation layer is located on a side of the pixel defining layer facing away from the substrate. The encapsulation layer includes a first encapsulation portion and a second encapsulation portion. An orthographic projection of the pixel opening on the substrate is within an orthographic projection of the first encapsulation portion on the substrate. An orthographic projection of the second encapsulation portion on the substrate is located between orthographic projections of adjacent pixel openings on the substrate. A thickness of the second encapsulation portion is less than that of the first encapsulation portion.

In another aspect, an embodiment of a fifth aspect of the present application further provides a display apparatus, including the display panel in any one of the above embodiments.

In another aspect, an embodiment of a sixth aspect of the present application further provides a method for manufacturing a display panel, applied to the display panel in any one of the above embodiments. The method includes: providing a substrate; forming a second electrode layer and a pixel defining layer on the substrate; manufacturing a patterned isolation structure on a side of the pixel defining layer facing away from the substrate, an opening being surrounded by the isolation structure; sequentially evaporating-and-depositing a light-emitting layer and a first electrode layer in the opening; forming a first encapsulation layer on a side of the first electrode layer facing away from the substrate; and etching away the isolation structure to form a first opening.

### BRIEF DESCRIPTION OF THE DRAWINGS

In order to more clearly illustrate the technical solutions in embodiments of the present application, the accompanying drawings used in the description of the embodiments of the present application will be briefly introduced below. For those of ordinary skill in the art, other drawings can be obtained according to the provided drawings without creative efforts.
FIG. 1 is a partial sectional view of a display panel according to an embodiment of the present application;
FIG. 2 is a partial sectional view of a display panel according to another embodiment of the present application;
FIG. 3 is a partial sectional view of a display panel according to yet another embodiment of the present application;
FIG. 4 is a partial sectional view of a display panel according to still another embodiment of the present application;
FIG. 5 is a partial sectional view of a display panel according to a further embodiment of the present application;
FIG. 6 is a partial sectional view of a display panel according to a further embodiment of the present application;
FIG. 7 is a top view of a display panel according to an embodiment of the present application; and
FIG. 8 is a partial enlarged view of the display panel in FIG. 7 at a position A with an encapsulation layer hidden according to an example.

### Reference signs:

10. substrate;
20. pixel defining layer; 21. pixel defining portion; 22. pixel opening;
30. encapsulation layer; 31. first encapsulation layer; 311. first opening; 312. encapsulation block; 32. second encapsulation layer; 321. second groove; 33. third encapsulation layer; 301. first encapsulation portion; 302. second encapsulation portion;
40. light-emitting layer; 50. first electrode layer; 60. first conductive line; 61. first conductive portion; 62. connecting portion;
70. second electrode layer; 80. isolation structure;
AA. display area; NA. non-display area;
z. thickness direction of a display panel.

### DETAILED DESCRIPTION

Features and exemplary embodiments in various aspects of the present application will be described in detail below. In order to make the objective, technical solutions, and advantages of the present application clearer, the present application will be described in further detail below with reference to the accompanying drawings and specific embodiments. It should be understood that the specific embodiments described herein are only intended to explain the present application, but not to limit the present application. For those skilled in the art, the present application can be implemented without some of these specific details. The following description of the embodiments is merely to provide a better understanding of the present application by illustrating the examples of the present application.

It should be noted that relational terms such as first and second herein are merely intended to distinguish one entity or operation from another entity or operation, and do not necessarily require or imply any actual relationship or sequence among these entities or operations. Moreover, terms "include", "comprise" or any other variants thereof are intended to cover non-exclusive inclusion, so that a process, method, article, or device including a series of elements not only include those elements, but also include other elements that are not explicitly listed, or further include elements inherent to the process, method, article or, device. In the absence of more limitations, an element defined by the statement "including ..." does not exclude the presence of additional identical elements in a process, method, article, or device that includes the element.

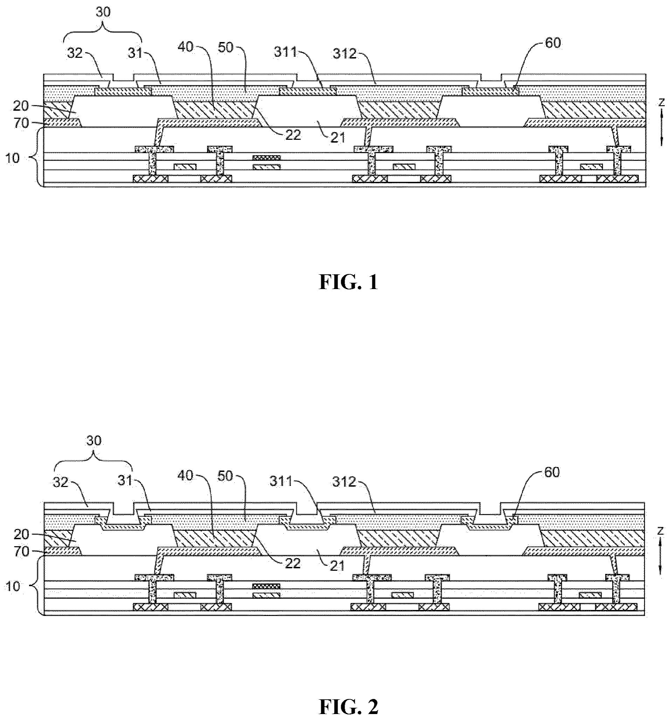

In order to better understand the present application, a display panel and a display apparatus of embodiments of the present application are described in detail below with reference to FIG. 1 to FIG. 8. It is noted that a direction z in the drawings is a thickness direction of the display panel. In the drawings, for the convenience of the drawings, dimensions in the figures are not necessarily proportional to actual dimensions, and some hierarchical structures in a display module are not shown.

Referring to FIG. 1, FIG. 1 is a partial sectional view of a display panel according to an embodiment of the present application.

As shown in FIG. 1, an embodiment of a first aspect of the present application provides a display panel, including a substrate 10, a pixel defining layer 20, and an encapsulation layer 30. The pixel defining layer 20 is arranged on the substrate 10. The encapsulation layer 30 is located on a side of the pixel defining layer 20 facing away from the substrate 10, and the encapsulation layer 30 includes a first encapsulation layer 31. The first encapsulation layer 31 is provided with a first opening 311 penetrating through the first encapsulation layer 31 along the thickness direction (the direction z in the figure).

In the display panel provided in this embodiment of the present application, the display panel includes the substrate 10, the pixel defining layer 20, and the encapsulation layer 30. The pixel defining layer 20 is arranged on the substrate 10. The encapsulation layer 30 is located on the side of the pixel defining layer 20 facing away from the substrate 10, and the encapsulation layer 30 includes a first encapsulation layer 31. The first encapsulation layer 31 is provided with the first opening 311 penetrating through the first encapsulation layer 31 along the thickness direction z, and the first encapsulation layer 31 is not a continuous entirety, so that in an encapsulation process of the display panel, independent encapsulation in partitions can be achieved, improving an encapsulation effect and applicability of the encapsulation process.

In some optional embodiments, the pixel defining layer 20 includes a pixel defining portion 21 and a pixel opening 22 surrounded by the pixel defining portion 21, and a light-emitting layer 40 is provided in the pixel opening 22. An orthographic projection of the first opening 311 on the substrate 10 is located between orthographic projections of adjacent pixel openings 22 on the substrate 10.

Optionally, a plurality of pixel openings 22 are distributed at intervals, and the light-emitting layer 40 is provided in each pixel opening 22.

Optionally, the first opening 311 divides the first encapsulation layer 31 into a plurality of encapsulation sections, and the plurality of encapsulation sections may be encapsulated sequentially in the encapsulation process, so that the light-emitting layers 40 corresponding to the plurality of encapsulation sections can also be sequentially manufactured in multiple processes to achieve functions such as partition control over the light-emitting layers 40. A plurality of first openings 311 may be spaced apart from each other, or may be connected to each other to form a shape of a grid. When the orthographic projections of the first openings 311 on the substrate 10 are in a shape of a grid, the first openings 311 divide the first encapsulation layer 31 into a plurality of encapsulation sections arranged at intervals.

In some optional embodiments, the orthographic projections of the first openings 311 on the substrate 10 are in a shape of a grid.

In some optional embodiments, the first encapsulation layer 31 includes a plurality of encapsulation blocks 312 arranged at intervals, and an orthographic projection of the pixel opening 22 on the substrate 10 is located within an orthographic projection of the encapsulation block 312 on the substrate 10.

Optionally, an orthographic projection of the light-emitting layer 40 on the substrate 10 is located within the orthographic projection of the encapsulation block 312 on the substrate 10.

Optionally, the first openings 311 in the shape of a grid divide the first encapsulation layer 31 into a plurality of encapsulation blocks 312 arranged at intervals.

In the display panel provided in this embodiment of the present application, the orthographic projection of the pixel opening 22 on the substrate 10 is located within the orthographic projection of the encapsulation block 312 on the substrate 10, so that the first encapsulation layer 31 ensures an encapsulation effect on the pixel opening 22 and can also achieve independent encapsulation of a plurality of sections.

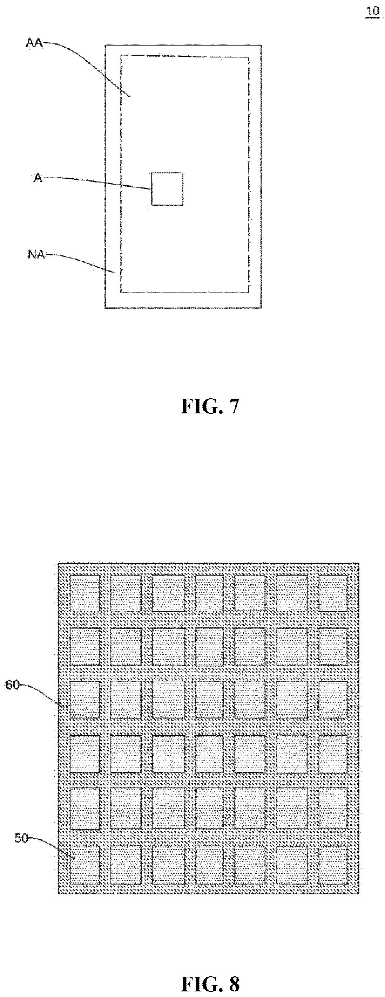

Referring to FIG. 1, FIG. 7, and FIG. 8, FIG. 7 is a top view of a display panel according to an embodiment of the present application; and FIG. 8 is a partial enlarged view of the display panel in FIG. 7 at a position A with an encapsulation layer hidden according to an example. The display panel includes a non-display area NA and a display area AA surrounded by the non-display area NA. The position A is located in the display area AA.

As shown in FIG. 1, FIG. 7, and FIG. 8, in some optional embodiments, the display panel may further include a first electrode layer 50 and a first conductive line 60. The first electrode layer 50 is located on a side of the light-emitting layer 40 facing away from the substrate 10. The first conductive line 60 is connected with the first electrode layer 50 in an overlap manner. An orthographic projection of the first conductive line 60 on the substrate 10 at least partially overlaps with the orthographic projection of the first opening 311 on the substrate 10.

Optionally, the first electrode layer 50 includes a plurality of first sub-electrodes (not marked), and each first sub-electrode is located on the side of the respective light-emitting layer 40 facing away from the substrate 10.

Optionally, the first conductive line 60 is connected with the first electrode layer 50 in an overlap manner, so that the plurality of first sub-electrodes connectable to the same power voltage through the first conductive line 60.

Optionally, the first conductive line 60 and the first electrode layer 50 are arranged in different layers.

In some optional embodiments, the encapsulation layer 30 may further include a second encapsulation layer 32. The second encapsulation layer 32 is located on a side of the first encapsulation layer 31 facing away from the substrate 10, and at least part of the second encapsulation layer 32 is located within the first opening 311.

Optionally, the second encapsulation layer 32 is provided with an entire surface.

Optionally, the orthographic projection of the first opening 311 on the substrate 10 is within an orthographic projection of the second encapsulation layer 32 on the substrate 10.

In the display panel provided in this embodiment of the present application, with the arrangement of the second encapsulation layer 32 on the side of the first encapsulation layer 31 facing away from the substrate 10, the second encapsulation layer 32 is configured to encapsulate the first conductive line 60 below the first opening 311 to improve an encapsulation effect of the display panel.

In some optional embodiments, the first conductive line 60 is located on the side of the pixel defining layer 20 facing away from the substrate 10.

Optionally, the orthographic projection of the first conductive line 60 on the substrate 10 is in a shape of a grid. The orthographic projection of the first conductive line 60 on the substrate 10 at least partially overlaps with the orthographic projection of the first opening 311 on the substrate 10.

Referring to FIG. 2, FIG. 2 is a partial sectional view of a display panel according to another embodiment of the present application.

Optionally, as shown in FIG. 2, a side of the pixel defining portion 21 facing away from the substrate 10 is provided with a first groove (not marked), and at least part of the first conductive line 60 is located in the first groove.

In the display panel provided in this embodiment of the present application, the side of the pixel defining portion 21 facing away from the substrate 10 is provided with the first groove accommodating the first conductive line 60, which reduces an overall thickness of the display panel, thereby increasing application scenarios of the display panel.

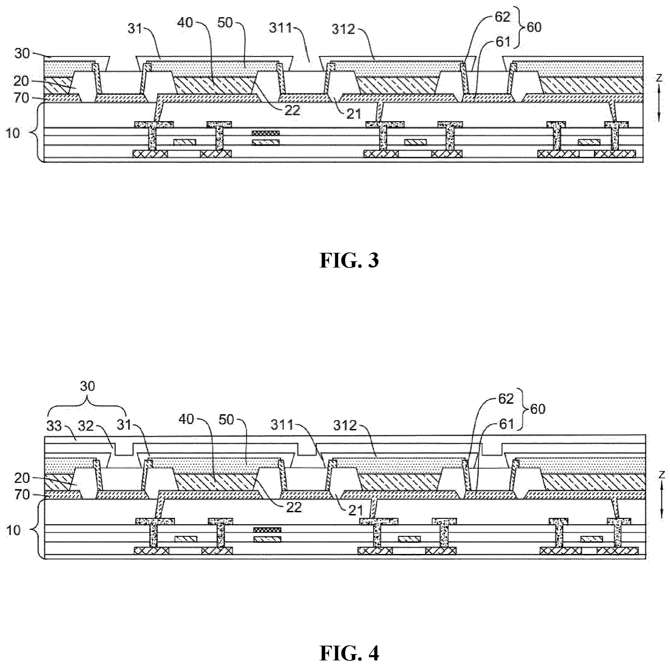

Referring to FIG. 3, FIG. 3 is a partial sectional view of a display panel according to yet another embodiment of the present application.

As shown in FIG. 3, in some optional embodiments, the first conductive line 60 includes a first conductive portion 61 and a connecting portion 62. The connecting portion 62 connects the first conductive portion 61 with the first electrode layer 50.

Optionally, the display panel may further include a second electrode layer 70. The second electrode layer 70 is located between the substrate 10 and the pixel defining layer 20. The first conductive portion 61 and the second electrode layer 70 are arranged in the same layer.

Optionally, the first conductive portion 61 is insulated from the second electrode layer 70. The second electrode layer 70 and the first electrode layer 50 interact with each other to drive the light-emitting layer 40 to emit light. One of the first electrode layer 50 and the second electrode layer 70 is an anode, and the other is a cathode. In this embodiment of the present application, the second electrode layer 70 is an anode, and the first electrode layer 50 is a cathode.

Optionally, the substrate 10 may include a base and a circuit layer. The circuit layer may include a driving circuit. For example, the circuit layer may include a first conductive layer, a second conductive layer, and a third conductive layer that are arranged on one side of the base and stacked. Insulating layers are arranged between adjacent conductive layers. Exemplarily, a pixel driving circuit arranged on the circuit layer includes a transistor and a storage capacitor. The transistor includes a semiconductor, a gate, a source, and a drain. The storage capacitor includes a first plate and a second plate. As an example, the gate and the first plate may be located on the first conductive layer, the second plate may be located on the second conductive layer, and the source and the drain may be located on the third conductive layer.

In the display panel provided in this embodiment of the present application, with the arrangement of the first conductive portion 61 and the second electrode layer 70 in the same layer, the overall thickness of the display panel is further reduced.

In some other optional embodiments, the first conductive portion 61 and the second electrode layer 70 are arranged in different layers, and the first conductive portion 61 is located within the substrate 10. The first conductive portion 61 may be arranged in the same layer as another conductive layer in the display panel. Exemplarily, the first conductive portion 61 may be arranged in the same layer as one of the first conductive layer, the second conductive layer, and the third conductive layer in the circuit layer.

In some optional embodiments, the pixel defining portion 21 is provided with a second opening (not marked) penetrating through the pixel defining portion 21 along the thickness direction z, and the connecting portion 62 connects the first conductive portion 61 with the first electrode layer 50 through the second opening.

Optionally, an orthographic projection of the connecting portion 62 on the substrate 10 is located outside the orthographic projection of the first opening 311 on the substrate 10.

In the display panel provided in this embodiment of the present application, the orthographic projection of the connecting portion 62 on the substrate 10 is located outside the orthographic projection of the first opening 311 on the substrate 10, so that the first electrode layer 50 is connectable to the connecting portion 62 in an overlap manner without extending below the first opening 311, ensuring an encapsulation effect of the encapsulation block 312 on the first electrode layer 50. The orthographic projection of the connecting portion 62 on the substrate 10 is located outside the orthographic projection of the first opening 311 on the substrate 10, so that the connecting portion 62 is sealed by the encapsulation block 312. Moreover, the first conductive portion 61 is located between the pixel defining layer 20 and the substrate 10, which means that the first conductive portion 61 is encapsulated by the pixel defining portion 21, the first conductive line 60 is encapsulated jointly by the encapsulation block 312 and the pixel defining portion 21, and there is no need to fill the first opening 311 with an encapsulation material, thereby reducing manufacturing processes, improving production efficiency, reducing a number of encapsulation layers, and also reducing the overall thickness of the display panel.

In some optional embodiments, the display panel further includes a power line (not shown). The power line is configured to provide a power voltage for the first electrode layer 50. The power line includes a first power line and a second power line insulated from each other. The first electrode layer 50 corresponding to adjacent pixel openings 22 is electrically connected to the first power line and the second power line respectively through two first conductive lines 60.

Optionally, the first power line and the second power line may provide different power voltages for the first electrode layer 50, and by electrically connecting the first electrode layer 50 corresponding to adjacent pixel openings 22 to the first power line and the second power line respectively through the two first conductive lines 60, partition control over the light-emitting layer 40 is realized.

In some optional embodiments, a material of the first encapsulation layer 31 includes an inorganic material, that is, the first encapsulation layer 31 is an inorganic encapsulation layer. The inorganic encapsulation layer may be manufactured by chemical vapor deposition, which can improve compactness of the first encapsulation layer 31, thereby improving an encapsulation effect of the encapsulation layer 30.

Referring to FIG. 4, FIG. 4 is a partial sectional view of a display panel according to still another embodiment of the present application.

Optionally, as shown in FIG. 4, the encapsulation layer 30 further includes a second encapsulation layer 32 located on the side of the first encapsulation layer 31 facing away from the substrate 10. A material of the second encapsulation layer 32 includes an organic material. That is, the second encapsulation layer 32 is an organic encapsulation layer. The organic encapsulation layer may be manufactured by inkjet printing, so that the encapsulation layer 30 has an appropriate thickness.

Optionally, at least part of the second encapsulation layer 32 is located within the first opening 311.

Optionally, the encapsulation layer 30 may further include a third encapsulation layer 33 located on a side of the second encapsulation layer 32 facing away from the substrate 10. A material of the third encapsulation layer 33 includes an inorganic material. That is, the third encapsulation layer 33 is an inorganic encapsulation layer. Adding an inorganic encapsulation layer outside the organic encapsulation layer can further improve the encapsulation effect of the encapsulation layer 30.

Optionally, the encapsulation layer may further include a fourth encapsulation layer (not shown) located between the first encapsulation layer 31 and the second encapsulation layer 32. A material of the fourth encapsulation layer includes an inorganic material, further improving the encapsulation effect of the encapsulation layer 30.

Optionally, the material of the first encapsulation layer 31 is the same as that of the third encapsulation layer 33. Therefore, the first encapsulation layer 31 and the third encapsulation layer 33 can be manufactured with a same device, which can simplify a manufacturing process of the display panel.

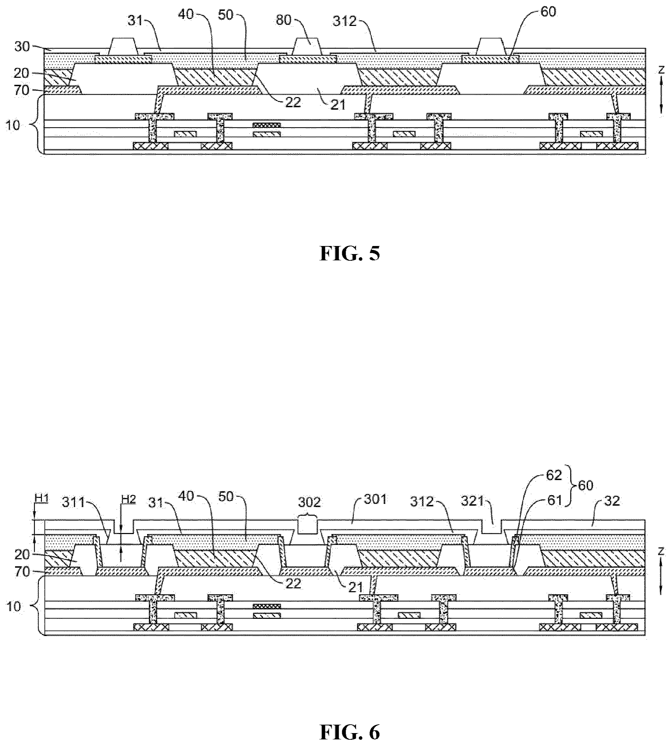

Referring to FIG. 5, FIG. 5 is a partial sectional view of a display panel according to a further embodiment of the present application. FIG. 1 may be understood as a state of the display panel in FIG. 5 after an isolation structure is removed.

In some optional embodiments, during the manufacturing of the display panel, firstly, the second electrode layer 70, the pixel defining layer 20, and the first conductive line 60 are manufactured on the substrate 10, and then a patterned isolation structure 80 is manufactured on the side of the pixel defining layer 20 facing away from the substrate 10. Then, the light-emitting layer 40 and the first electrode layer 50 are sequentially formed via evaporation-deposition in an opening surrounded by the isolation structure 80, and a first encapsulation layer 31 is then manufactured for encapsulation. The first encapsulation layer 31 does not completely cover the isolation structure 80, and the isolation structure 80 divides the first encapsulation layer 31, the light-emitting layer 40, and the first electrode layer 50 into a plurality of independent sections. Then, the isolation structure 80 is removed by an etching process. A space left after the isolation structure 80 is removed is the first opening 311. Finally, another encapsulation layer is manufactured on the side of the first encapsulation layer 31 facing away from the substrate 10 as required.

Optionally, a material of the isolation structure 80 includes a metal material. In the display panel provided in this embodiment of the present application, the opening is surrounded by the isolation structure, and the light-emitting layer 40 is formed via evaporation-deposition in the opening, so that there is no need to use a precision mask to form the light-emitting layer 40 via evaporation-deposition, which can simplify the manufacturing process of the display panel and can also improve resolution of the display panel without process limitations of the precision mask. In the display panel manufactured with the precision mask, lateral leakage is prone to occur between adjacent pixels, and the first electrode layer is manufactured by entire-surface evaporation-deposition, resulting in a small thickness and high impedance. However, in the display panel provided in this embodiment of the present application, the first conductive line 60 is thicker, which reduces the impedance, thereby reducing power consumption of the display panel. Secondly, by removing the isolation structure after the evaporation-deposition of the light-emitting layer 40, the overall thickness of the display panel is reduced.

As shown in FIG. 3 and FIG. 4, a further embodiment of the present application further provides a display panel. The display panel includes the substrate 10, the pixel defining layer 20, the first electrode layer 50, and the first conductive line 60. The pixel defining layer 20 is arranged on the substrate 10, the pixel defining layer 20 includes the pixel defining portion 21 and the pixel opening 22 surrounded by the pixel defining portion 21, and the light-emitting layer 40 is provided in the pixel opening 22. The first electrode layer 50 is located on the side of the light-emitting layer 40 facing away from the substrate 10. The first conductive line 60 includes the first conductive portion 61 which is located between the substrate 10 and the pixel defining layer 20. The first conductive portion 61 is electrically connected to the first electrode layer 50.

In the display panel provided in this embodiment of the present application, the display panel includes the substrate 10, the pixel defining layer 20, the first electrode layer 50, and the first conductive line 60. The pixel defining layer 20 is arranged on the substrate 10, the pixel defining layer 20 includes the pixel defining portion 21 and the pixel opening 22 surrounded by the pixel defining portion 21, and the light-emitting layer 40 is provided in the pixel opening 22. The first electrode layer 50 is located on the side of the light-emitting layer 40 facing away from the substrate 10. The first conductive line 60 includes a first conductive portion 61, and the first conductive portion 61 is electrically connected to the first electrode layer 50. By locating the first conductive portion 61 between the substrate 10 and the pixel defining layer 20, a space between the pixel defining layer 20 and the substrate 10 is fully utilized to arrange the first conductive portion 61, thereby reducing the overall thickness of the display panel. By locating the first conductive portion 61 between the substrate 10 and the pixel defining layer 20, the first conductive portion 61 is encapsulated by the pixel defining layer 20, thereby reducing the encapsulating process and improving production efficiency.

In some optional embodiments, the display panel may further include the encapsulation layer 30. The encapsulation layer 30 is located on the side of the pixel defining layer 20 facing away from the substrate 10. The encapsulation layer 30 includes a first encapsulation layer 31. The first encapsulation layer 31 is provided with the first opening 311 penetrating through the first encapsulation layer 31 along the thickness direction z.

Optionally, the orthographic projection of the first opening 311 on the substrate 10 is located between orthographic projections of adjacent pixel openings 22 on the substrate 10. The first encapsulation layer 31 includes a plurality of encapsulation blocks 312 arranged at intervals. The orthographic projection of the pixel opening 22 on the substrate 10 is located within the orthographic projection of the encapsulation block 312 on the substrate 10. In some optional embodiments, the display panel may further include a second electrode layer 70. The second electrode layer 70 is located between the substrate 10 and the pixel defining layer 20. The first conductive portion 61 and the second electrode layer 70 are arranged in the same layer.

In the display panel provided in this embodiment of the present application, by arranging the first conductive portion 61 and the second electrode layer 70 in the same layer, an internal space is fully utilized, and the overall thickness of the display panel is further reduced.

In some optional embodiments, the first conductive line 60 further includes a connecting portion 62, and the connecting portion 62 connects the first conductive portion 61 with the first electrode layer 50.

Optionally, the pixel defining portion 21 is provided with the second opening penetrating through the pixel defining portion 21 along the thickness direction z, and the connecting portion 62 connects the first conductive portion 61 with the first electrode layer 50 through the second opening.

Optionally, the orthographic projection of the connecting portion 62 on the substrate 10 is located outside the orthographic projection of the first opening 311 on the substrate 10.

In the display panel provided in this embodiment of the present application, the orthographic projection of the connecting portion 62 on the substrate 10 is located outside the orthographic projection of the first opening 311 on the substrate 10, so that the first electrode layer 50 is connectable with the connecting portion 62 in an overlap manner without extending below the first opening 311, ensuring an encapsulation effect of the encapsulation block 312 on the first electrode layer 50.

In some optional embodiments, an orthographic projection of the first conductive portion 61 on the substrate 10 is located between orthographic projections of adjacent pixel openings 22 on the substrate 10.

In some optional embodiments, the display panel further includes a power line, the power line is configured to provide a power voltage for the first electrode layer 50, and the power line includes a first power line and a second power line insulated from each other. The first electrode layer 50 corresponding to adjacent pixel openings 22 is electrically connected to the first power line and the second power line respectively through two first conductive lines 60.

Optionally, the first power line and the second power line may provide different power voltages for the first electrode layer 50, and by electrically connecting the first electrode layer 50 corresponding to adjacent pixel openings 22 to the first power line and the second power line respectively through the two first conductive lines 60, independent partition control over the light-emitting layer 40 is realized.

As shown in FIG. 1 and FIG. 2, a further embodiment of the present application further provides a display panel. The display panel includes the substrate 10, the pixel defining layer 20, the first electrode layer 50, and the first conductive line 60. The pixel defining layer 20 is arranged on the substrate 10. The pixel defining layer 20 includes the pixel defining portion 21 and the pixel opening 22 surrounded by the pixel defining portion 21. The light-emitting layer 40 is provided in the pixel opening 22. The first electrode layer 50 is located on the side of the light-emitting layer 40 facing away from the substrate 10. The first conductive line 60 is located on the side of the pixel defining layer 20 away from the substrate 10, and the first conductive line 60 is connected with the first electrode layer 50 in an overlap manner.

In some optional embodiments, the display panel may further include the encapsulation layer 30. The encapsulation layer 30 is located on the side of the pixel defining layer 20 facing away from the substrate 10, and the encapsulation layer 30 includes the first encapsulation layer 31. The first encapsulation layer 31 is provided with the first opening 311 penetrating through the first encapsulation layer 31 along the thickness direction z.

Optionally, the orthographic projection of the first opening 311 on the substrate 10 is located between orthographic projections of adjacent pixel openings 22 on the substrate 10. The first encapsulation layer 31 includes a plurality of encapsulation blocks 312 arranged at intervals, and the orthographic projection of the pixel opening 22 on the substrate 10 is located within the orthographic projection of the encapsulation block 312 on the substrate 10.

In some optional embodiments, the orthographic projection of the first conductive line 60 on the substrate 10 is located between orthographic projections of adjacent pixel openings 22 on the substrate 10.

In some optional embodiments, the orthographic projection of the first conductive line 60 on the substrate 10 is in a shape of a grid.

Optionally, the side of the pixel defining portion 21 facing away from the substrate 10 is provided with the first groove (not marked), and at least part of the first conductive line 60 is located in the first groove.

In the display panel provided in this embodiment of the present application, the side of the pixel defining portion 21 facing away from the substrate 10 is provided with the first groove accommodating the first conductive line 60, which reduces an overall thickness of the display panel, thereby increasing application scenarios of the display panel.

Referring to FIG. 6, FIG. 6 is a partial sectional view of a display panel according to a further embodiment of the present application.

As shown in FIG. 6, a further embodiment of the present application further provides a display panel. The display panel includes the substrate 10, the pixel defining layer 20, and the encapsulation layer 30. The pixel defining layer 20 is arranged on the substrate 10. The pixel defining layer 20 includes the pixel opening 22. The light-emitting layer 40 is provided in the pixel opening 22. The encapsulation layer 30 is located on the side of the pixel defining layer 20 facing away from the substrate 10. The encapsulation layer 30 includes a first encapsulation portion 301 and a second encapsulation portion 302. The orthographic projection of the pixel opening 22 on the substrate 10 is within an orthographic projection of the first encapsulation portion 301 on the substrate 10. An orthographic projection of the second encapsulation portion 302 on the substrate 10 is located between orthographic projections of adjacent pixel openings 22 on the substrate 10. A thickness of the second encapsulation portion 302 is less than that of the first encapsulation portion 301.

In some optional embodiments, the pixel defining layer 20 may further include the pixel defining portion 21, and the pixel opening 22 is surrounded by the pixel defining portion 21.

In some optional embodiments, the encapsulation layer 30 includes the first encapsulation layer 31 and the second encapsulation layer 32, the first encapsulation layer 31 is located between the second encapsulation layer 32 and the pixel defining layer 20. The first encapsulation layer 31 is provided with the first opening 311 penetrating through the first encapsulation layer 31 along the thickness direction z. The orthographic projection of the first opening 311 on the substrate 10 is located between the orthographic projections of the adjacent pixel openings 22 on the substrate 10.

Optionally, the first encapsulation layer 31 includes a plurality of encapsulation blocks 312 arranged at intervals, and the orthographic projection of the pixel opening 22 on the substrate 10 is located within the orthographic projection of the encapsulation block 312 on the substrate 10. The first opening 311 in the shape of a grid divides the first encapsulation layer 31 into a plurality of encapsulation blocks 312 arranged at intervals.

Optionally, at least part of the second encapsulation layer 32 is located in the first opening 311, so that a second groove 321 is formed on the side of the encapsulation layer 30 facing away from the pixel defining layer 20. An orthographic projection of the second groove 321 on the substrate 10 at least partially overlaps with the orthographic projection of the first opening 311 on the substrate 10, and the orthographic projection of the second groove 321 on the substrate 10 overlaps with the orthographic projection of the second encapsulation portion 302 on the substrate 10.

Optionally, the first encapsulation portion 301 corresponds to an area where the encapsulation block 312 and the second encapsulation layer 32 are stacked, and the second encapsulation portion 302 corresponds to an area where the second groove 321 is located, that is, an area where the second encapsulation layer 32 fills the first opening 311. Therefore, a thickness of the first encapsulation portion 301 is a sum of the thickness of the encapsulation block 312 and the thickness of the second encapsulation layer 32 (a dimension H1 in the figure). A thickness of the second encapsulation portion 302 is the thickness of the second encapsulation layer 32 (a dimension H2 in the figure). The dimension H2 is less than the dimension H1, and the thickness of the second encapsulation portion 302 is less than the thickness of the first encapsulation portion 301.

An embodiment of a second aspect of the present application further provides a display apparatus, including the display panel in any one of the above embodiments in the first aspect. Since the display apparatus provided in the embodiment of the second aspect of the present application includes the display panel in any one of the above embodiments in the first aspect, the display apparatus provided in the embodiment of the second aspect of the present application has the beneficial effects of the display panel in any one of the above embodiments in the first aspect. Details are not described herein again.

The display apparatus in the embodiments of the present application includes, but is not limited to, a mobile phone, a personal digital assistant (PDA), a tablet computer, an e-book, a television, an access control, a smart fixed phone, a console, and other devices with a display function.

Referring to FIG. 1 to FIG. 6, another embodiment of the present application further provides a method for manufacturing a display panel, applied to the display panel in any one of the above embodiments in the first aspect. The method includes: providing the substrate 10; forming the second electrode layer 70 and the pixel defining layer 20 on the substrate 10; manufacturing the patterned isolation structure 80 on the side of the pixel defining layer 20 facing away from the substrate 10, the opening being surrounded by the isolation structure 80; sequentially evaporating-and-depositing the light-emitting layer 40 and the first electrode layer 50 in the opening; forming the first encapsulation layer 31 on the side of the first electrode layer 50 facing away from the substrate 10; and etching away the isolation structure 80 to form the first opening 311.

The above are merely specific implementations of the present application. It may be clearly understood by those skilled in the art that, for the purpose of convenient and brief description, detailed working processes of the systems, modules, and units described above may be obtained with reference to the corresponding processes in the foregoing method embodiments, which are not described herein again. It should be understood that the protection scope of the present application is not limited thereto. Any person skilled in the art can readily figure out various equivalent modifications or replacements within the technical scope disclosed in the present application, and such modifications or replacements shall fall within the protection scope of the present application.

## Claims

1. A display panel, comprising:
a substrate;
a pixel defining layer arranged on the substrate; and
an encapsulation layer located on a side of the pixel defining layer facing away from the substrate, the encapsulation layer including a first encapsulation layer, the first encapsulation layer being provided with a first opening penetrating through the first encapsulation layer along a thickness direction.

2. The display panel of claim 1, wherein the pixel defining layer includes a pixel defining portion and a pixel opening surrounded by the pixel defining portion, a light-emitting layer is provided in the pixel opening, and an orthographic projection of the first opening on the substrate is located between orthographic projections of adjacent pixel openings on the substrate.

3. The display panel of claim 2, wherein the orthographic projection of the first opening on the substrate is in a shape of a grid.

4. The display panel of claim 3, wherein the first encapsulation layer includes a plurality of encapsulation blocks arranged at intervals, and the orthographic projection of the pixel opening on the substrate is located within an orthographic projection of the encapsulation block on the substrate.

5. The display panel of claim 4, wherein an orthographic projection of the light-emitting layer on the substrate is located within the orthographic projection of the encapsulation block on the substrate.

6. The display panel of claim 2, further comprising:
a first electrode layer located on a side of the light-emitting layer facing away from the substrate; and
a first conductive line located on the substrate, the first conductive line being connected with the first electrode layer in an overlap manner, and an orthographic projection of the first conductive line on the substrate at least partially overlapping with the orthographic projection of the first opening on the substrate.

7. The display panel of claim 6, wherein the first conductive line is located on the side of the pixel defining layer facing away from the substrate.

8. The display panel of claim 7, wherein the orthographic projection of the first conductive line on the substrate is in a shape of a grid.

9. The display panel of claim 7, wherein a side of the pixel defining portion facing away from the substrate is provided with a first groove, and at least part of the first conductive line is located in the first groove.

10. The display panel of claim 6, wherein the first conductive line includes a first conductive portion and a connecting portion, and the connecting portion connects the first conductive portion with the first electrode layer.

11. The display panel of claim 10, wherein the display panel further comprises a second electrode layer, the second electrode layer is located between the substrate and the pixel defining layer, and the first conductive portion and the second electrode layer are arranged in a same layer.

12. The display panel of claim 10, wherein the first conductive portion is located within the substrate.

13. The display panel of claim 10, wherein the pixel defining portion is provided with a second opening penetrating through the pixel defining portion along the thickness direction, and the connecting portion connects the first conductive portion with the first electrode layer through the second opening.

14. The display panel of claim 13, wherein an orthographic projection of the connecting portion on the substrate is located outside the orthographic projection of the first opening on the substrate.

15. The display panel of claim 6, further comprising a power line, wherein the power line is configured to provide a power voltage for the first electrode layer, and the power line includes a first power line and a second power line insulated from each other; and
the first electrode layer corresponding to adjacent pixel openings is electrically connected to the first power line and the second power line respectively through two first conductive lines.

16. The display panel of claim 1, wherein a material of the first encapsulation layer includes an inorganic material.

17. The display panel of claim 16, wherein the encapsulation layer further includes a second encapsulation layer, a third encapsulation layer, and a fourth encapsulation layer;
the second encapsulation layer is located on a side of the first encapsulation layer facing away from the substrate, and a material of the second encapsulation layer includes an organic material;
the third encapsulation layer is located on a side of the second encapsulation layer facing away from the substrate, and a material of the third encapsulation layer includes an inorganic material;
the fourth encapsulation layer is located between the first encapsulation layer and the second encapsulation layer, and a material of the fourth encapsulation layer includes an inorganic material; and
the material of the first encapsulation layer is the same as that of the third encapsulation layer.

18. A display panel, comprising:
a substrate;
a pixel defining layer arranged on the substrate, the pixel defining layer including a pixel defining portion and a pixel opening surrounded by the pixel defining portion, and a light-emitting layer being provided in the pixel opening;
a first electrode layer located on a side of the light-emitting layer facing away from the substrate; and
a first conductive line including a first conductive portion, the first conductive portion being located between the substrate and the pixel defining layer, and the first conductive portion being electrically connected to the first electrode layer.

19. The display panel of claim 18, further comprising a second electrode layer, the second electrode layer being located between the substrate and the pixel defining layer, and the first conductive portion and the second electrode layer being arranged in a same layer.

20. The display panel of claim 19, wherein the first conductive line further includes a connecting portion, and the connecting portion connects the first conductive portion with the first electrode layer.

21. The display panel of claim 18, wherein an orthographic projection of the first conductive portion on the substrate is located between orthographic projections of adjacent pixel openings on the substrate.

22. The display panel of claim 18, further comprising a power line, wherein the power line is configured to provide a power voltage for the first electrode layer, and the power line includes a first power line and a second power line insulated from each other; and
at least two first conductive lines are insulated from each other, and one is connected to the first power line and another one is connected to the second power line.

23. A display panel, comprising:
a substrate;
a pixel defining layer arranged on the substrate, the pixel defining layer including a pixel defining portion and a pixel opening surrounded by the pixel defining portion, and a light-emitting layer being provided in the pixel opening;
a first electrode layer located on a side of the light-emitting layer facing away from the substrate; and
a first conductive line located on a side of the pixel defining layer away from the substrate, the first conductive line being connected with the first electrode layer in an overlap manner.

24. The display panel of claim 23, wherein an orthographic projection of the first conductive line on the substrate is located between orthographic projections of adjacent pixel openings on the substrate.

25. The display panel of claim 23, wherein an orthographic projection of the first conductive line on the substrate is in a shape of a grid.

26. A display panel, comprising:
a substrate;
a pixel defining layer arranged on the substrate, the pixel defining layer including a pixel opening, and a light-emitting layer being provided in the pixel opening; and
an encapsulation layer located on a side of the pixel defining layer facing away from the substrate, the encapsulation layer including a first encapsulation portion and a second encapsulation portion, an orthographic projection of the pixel opening on the substrate being within an orthographic projection of the first encapsulation portion on the substrate, an orthographic projection of the second encapsulation portion on the substrate being located between orthographic projections of adjacent pixel openings on the substrate, and a thickness of the second encapsulation portion being less than that of the first encapsulation portion.

27. The display panel of claim 26, wherein the pixel defining layer further includes a pixel defining portion, wherein the pixel opening is surrounded by the pixel defining portion.

28. The display panel of claim 26, wherein the encapsulation layer includes a first encapsulation layer and a second encapsulation layer, the first encapsulation layer is located between the second encapsulation layer and the pixel defining layer; and
the first encapsulation layer is provided with a first opening penetrating through the first encapsulation layer along a thickness direction, and an orthographic projection of the first opening on the substrate is located between the orthographic projections of the adjacent pixel openings on the substrate.

29. A display apparatus, comprising the display panel of any one of claims 1 to 28.

30. A method for manufacturing a display panel, applied to the display panel of any one of claims 1 to 28, the method comprising:
providing a substrate;
forming a second electrode layer and a pixel defining layer on the substrate;
manufacturing a patterned isolation structure on a side of the pixel defining layer facing away from the substrate, an opening being surrounded by the isolation structure;
sequentially evaporating-and-depositing a light-emitting layer and a first electrode layer in the opening;
forming a first encapsulation layer on a side of the first electrode layer facing away from the substrate; and
etching away the isolation structure to form a first opening.
